# FASCICULE DE BREVET EUROPEEN

(11) **EP 2 824 622 B1**
(45) Date de publication et mention de la délivrance du brevet: **06.09.2017**
(21) Numéro de dépôt: 14176231.0
(22) Date de dépôt: 09.07.2014
(51) Int. Cl.: G06Q 20/00, G07G 1/12, G07G 1/00, B65D 55/06, H05K 5/00

(54) **Flexible sécurisé**
Gesicherter Schlauch
Secure hose

(30) Priorité: 12.07.2013 FR 1356873
(43) Date de publication de la demande: 14.01.2015
(73) Titulaire: Ingenico Group, 75015 Paris (FR)
(72) Inventeur: Georges, Didier, 26120 Chabeuil (FR); Wolff, Caroline, 92150 Suresnes (FR); Lebonnois, Etienne, 26730 La Baume d'Hostun (FR); Estorges, Stéphane, 75015 Paris (FR)
(74) Mandataire: Vidon Brevets & Stratégie

(56) Documents cités:
- CN-A- 101 295 510
- US-A1- 2012 092 837
- US-A1- 2014 009 878

## Description

### 1. Domaine de l'invention

L'invention concerne les dispositifs électroniques comprenant plusieurs circuits imprimés. De tels systèmes sont par exemple utilisés dans des dispositifs électroniques tels que des terminaux de paiement, de lecteurs de cartes à puces, des consoles de jeux ou encore des lecteurs multimédia. Cette liste illustre très partiellement la multitude de dispositifs du quotidien qui comprennent des systèmes électroniques comprenant généralement plusieurs circuits imprimés.

La nécessité d'utiliser plusieurs circuits imprimés dans un système électronique est généralement dictée par des impératifs liés au produit dans lequel ce système électronique est destiné à être positionné. En effet en fonction de la forme du produit, il peut être nécessaire de prévoir plusieurs circuits imprimés qui vont être reliés les uns aux autres.

La forme du produit n'est pas nécessairement la seule raison pour laquelle il peut être nécessaire d'utiliser un système comprenant plusieurs circuits imprimés. Cette nécessité peut également être guidée par des impératifs liés à la place disponible.

### 2. Art antérieur

Un des problèmes qui se pose avec les systèmes électroniques comprenant plusieurs circuits imprimés est celui de la liaison entre ces circuits imprimés. En effet, pour pouvoir fournir les fonctions attendues, il est généralement nécessaire de relier les circuits imprimés composant le système. Pour relier les circuits imprimés, on utilise des connecteurs. Ces connecteurs posent des problèmes d'une part de fiabilité et d'autre part de sécurité. Le problème de sécurité est particulièrement gênant dans les dispositifs qui gèrent des données confidentielles comme les terminaux de paiement, les lecteurs de cartes de paiement, etc. En effet, des signaux sensibles transitent entre les circuits imprimés. Ces signaux sensibles sont par exemple représentatifs d'un compte bancaire, d'un code secret (« pin code »). Ce problème de sécurité doit donc être résolu.

En d'autres termes, les problèmes rencontrés par les circuits connus sont notamment liés aux interconnexions mécaniques indispensables pour permettre d'une part la liaison de plusieurs circuits imprimés entre eux et d'autre part pour offrir des formes originales aux produits une fois assemblés.

Or ces interconnexions mécaniques (qui sont réalisées sous la forme de connecteur carte à carte, lorsque deux cartes doivent être interconnectées, ou sous la forme d'une nappe flexible connectée à deux connecteurs présents sur chacune des deux cartes) nécessitent des protections particulières pour empêcher l'espionnage des signaux qui y transitent. C'est plus particulièrement le cas des nappes flexibles par lesquelles les signaux transitent.

Les nappes flexibles possèdent des propriétés intéressantes, puisqu'elles sont flexibles comme des nappes traditionnelles, mais elles sont réalisées sensiblement comme des circuits imprimés rigides. Afin de sécuriser ces nappes flexibles, on y ajoute des couches : il y a par exemple une ou plusieurs couches pour faire transiter des signaux utiles. Il peut également y avoir une ou plusieurs couches avec un plan de masse. Pour protéger le flexible, on ajoute une ou deux couches comprenant un treillis de protection. Cette solution de sécurisation est éprouvée et apporte satisfaction au niveau de la sécurité. En revanche, cette solution entraine des problèmes de flexibilité. En effet, plus on ajoute de couches à la nappe et moins elle est flexible. La nappe ne peut donc plus être utilisée facilement et des risques de cassure, au moins partiels, existent. Le brevet CN 101295510 A du 29 octobre 2008 est un exemple d'un tel circuit imprimé flexible sécurisé.

### 3. Résumé de l'invention

L'invention ne pose pas ces problèmes liés aux systèmes de l'art antérieur. En effet, l'invention concerne un circuit imprimé comprenant au moins une partie flexible.

Selon l'invention, ladite partie flexible comprend au moins une couche, dite couche de transport comprenant au moins une piste de cuivre de transmission de signal, et au moins une couche de support, ladite au moins une couche de support comprenant au moins une piste faisant office de plan de masse et au moins une piste de protection d'au moins une desdites pistes de transmission de signal.

Selon une caractéristique particulière, ladite couche de transport comprend au moins une piste de transmission d'un signal à protéger et ladite au moins une piste de protection de ladite au moins une couche de support est conformée pour recouvrir au moins partiellement ladite au moins une piste de transmission d'un signal à protéger.

Selon une caractéristique particulière, ladite au moins une piste faisant office de plan de masse de ladite couche de support est conformée pour recouvrir au moins partiellement au moins une piste de transmission de signal.

Selon une caractéristique particulière, ladite couche de transport comprend au moins une piste de transmission d'un signal à protéger et ladite au moins une piste d'un signal à protéger de ladite couche de transport est disposée à proximité et de manière sensiblement parallèle à une droite de symétrie axiale de la dite couche de transport.

Selon une caractéristique particulière, ladite au moins une piste de protection de ladite au moins une couche de support est conformée pour recouvrir au moins partiellement ladite au moins une piste de transmission d'un signal à protéger, en dessinant une pluralité de circonvolutions sur une surface sensiblement équivalente à la surface occupée par ladite au moins une piste de transmission d'un signal à protéger sur ladite couche de transport.

Selon une caractéristique particulière, ladite au moins une piste faisant office de plan de masse occupe une surface sensiblement équivalente à la surface occupée par ladite au moins une piste de transmission d'un signal standard sur ladite couche de transport.

Selon une caractéristique particulière, ladite couche de transport comprend au moins une piste de transmission d'un signal à protéger et ladite couche de transport comprend une piste de masse reliée audit plan de masse de ladite couche de support par l'intermédiaire d'au moins une via.

### 4. Figures

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :
- La figure 1 illustre une vue de côté d'un circuit imprimé flexible objet de la présente divulgation ;
- La figure 2a présente une vue de dessus de la couche de transport d'un mode de réalisation d'un circuit imprimé flexible objet de la présente divulgation ;
- La figure 2b présente une vue de dessus de la couche de support d'un mode de réalisation d'un circuit imprimé flexible objet de la présente divulgation ;

### 5. Description d'un mode de réalisation

### 5.1. Rappel du principe général de l'invention

Il est communément admis que le coût de la sécurisation d'un système augmente exponentiellement avec le nombre d'éléments à sécuriser dans le système : c'est particulièrement le cas dans un système tel que celui présenté dans lequel chaque élément (carte, connecteur, nappe) doit faire l'objet d'une sécurisation particulière. La sécurisation d'une nappe n'est en effet pas la même opération que la sécurisation d'un connecteur ou d'une carte de circuit imprimé. Les coûts de sécurisation sont donc multipliés. De plus, comme exposé précédemment, la multiplication des couches sur le circuit imprimé flexible entraine une baisse voire une quasi absence de flexibilité.

Pour conserver la flexibilité du flexible tout en assurant une sécurité optimum et une tolérance importante aux perturbations électromagnétiques, les inventeurs ont eu l'idée de concevoir un circuit imprimé flexible comprenant une couche, dite couche de support, ayant la double fonction : treillis de protection d'une part et plan de masse d'autre part. La figure présente une vue en trois dimensions schématique de la technique proposée.

Les inventeurs ont placé, sur la couche de support, un treillis dont la surface occupe sensiblement la même surface que celle des pistes à protéger sur la couche de transport et un plan de masse, qui occupe sensiblement la surface restante (c'est-à-dire la surface qui n'est pas occupée par la piste formant le treillis). Bien entendu, cette configuration est modifiable. Il peut par exemple y avoir plusieurs pistes formant un treillis. Bien que cela ne soit pas usuel, il peut également avoir plusieurs pistes distinctes et non interconnectées qui forment le plan de masse (dans ce cas, chacune de ces pistes distinctes est connectée à la masse à un autre endroit dans le dispositif électronique).

Dans le mode de réalisation présenté ci-après, les pistes à protéger sont placées sensiblement au centre du flexible (centre défini par rapport à un axe de symétrie qui diviserai le flexible en deux). Bien entendu, la configuration présentée ci-après n'est pas limitative et il est tout à fait envisageable de mettre en oeuvre tout autre type de configuration dans laquelle une couche de support remplie à la fois la fonction de protection de signaux sensibles et la fonction de protection des perturbations électromagnétiques.

### 5.2. Description d'un mode de réalisation particulier

Dans ce mode de réalisation, on n'utilise que deux couches pour le flexible. En revanche, la sécurité du flexible n'est pas impactée. En effet, plutôt que de multiplier les couches, les inventeurs ont identifié le moyen d'obtenir à la fois la sécurité nécessaire et les moyens d'assurer une bonne compatibilité électromagnétique.

Dans ce mode de réalisation, le flexible comprend deux couches : une couche comprenant les pistes des signaux dont il faut réaliser le transport par l'intermédiaire de la nappe et une couche dite de support ayant à la fois un fonction de protection contre l'intrusion et à la fois une fonction de compatibilité électromagnétique. Dans la mesure où une seule couche assure ces deux fonctions, la nappe conserve ses propriétés de flexibilité.

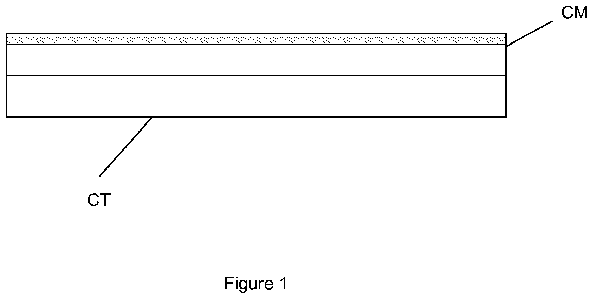

La figure 1 Expose brièvement ce principe : la nappe flexible comprend une couche de transport CT et une couche de support CS. Sur la couche de support, on trouve à la fois un plan de masse et un dispositif de protection.

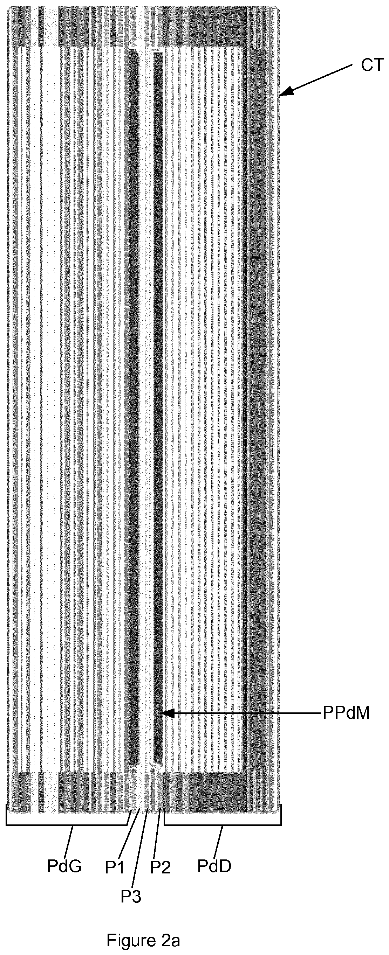

Dans ce mode de réalisation, les pistes à protéger ont été regroupées en portion centrale de la première couche du flexible (couche de transport, CT). Dans l'exemple de la figure 2a, ces pistes à protéger sont au nombre de trois (P1, P2, P3). Les pistes se situant sur le côté gauche (PdG) et sur le côté droit (PdD) de la couche de transport véhiculent des signaux qui ne nécessitent pas de protection. Ces signaux ne sont pas sensibles en termes d'informations transportées (les signaux sont appelés « standard »).

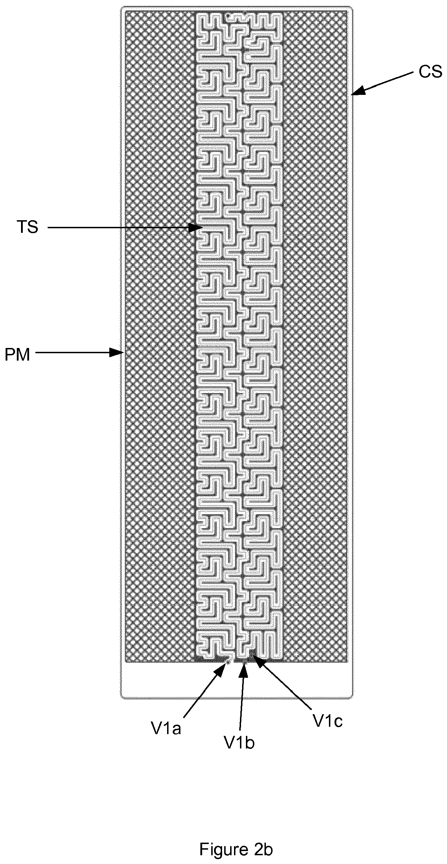

Dans ce mode de réalisation, comme présenté en relation avec la figure 2b, la couche de support (CS) comprend à la fois un plan de masse (PM), utilisé pour assurer une compatibilité électromagnétique, et un treillis (TS), dessiné pour protéger les pistes à protéger (pistes sensibles, P1, P2, P3). Le treillis, dans ce mode de réalisation est positionné au-dessus des pistes à protéger. Le treillis à une forme particulière, dessinant un chemin continu entre les deux extrémités de la couche de support. Lorsque la couche de support (CS) est superposée sur la couche de transport (CT), les pistes des signaux à protéger (P1, P2, P3) sont situées sous le treillis (TS) tandis que les pistes des signaux standards (PdG, PdD) sont situées sous le plan de masse (PM). Selon une caractéristique particulière, le plan de masse s'étend au niveau de l'espace laissé libre par les circonvolutions de la piste formant le treillis de protection. De cette manière, le plan de masse joue également son rôle au niveau des pistes des signaux à protéger.

Par ailleurs, dans la technique décrite dans ce mode de réalisation, la couche de support (CS) comprend une via (V1a) permettant de réaliser une connexion entre la couche de support et la couche de transport pour le treillis (TS). Ainsi, comme exposé en figure 2a et en figure 2b, le treillis comprend également une connexion sur la couche de transport, ce qui facilite la connexion du flexible sécurisé d'une part (puisqu'il n'est pas nécessaire de prévoir une connexion séparée pour la piste correspondant au treillis) et qui permet d'autre part d'assurer une sécurisation supplémentaire (puisque le signal qui est transporté par le treillis est positionné à proximité du signal à protéger : cela évite, par voie de conséquence, que la piste du signal à protéger soit « attaquée » par le côté du flexible).

De plus, dans la technique décrite dans ce mode de réalisation, la couche de support comprend une via (V1b) permettant de réaliser une connexion entre la couche de support et la couche de transport pour le plan de masse (PM). Ainsi, comme exposé en figure 2a et en figure 2b, le plan de masse (PM) comprend également une connexion sur la couche de transport, ce qui facilite la connexion du flexible sécurisé (puisqu'il n'est pas nécessaire de prévoir une connexion séparée pour la piste correspondant au treillis).

De plus, dans la technique décrite dans ce mode de réalisation, la couche de support comprend une via (V1c) permettant de réaliser une connexion entre le plan de masse de la couche de support (PM) et une piste spécifique (PPdM), jouant également le rôle de plan de masse de la couche de transport. Cette piste spécifique du plan de masse (PPdM) assure une protection électromagnétique supplémentaire à côté de la piste transportant le signal à protéger.

## Revendications

1. Circuit imprimé (Cl) comprenant au moins une partie flexible, ladite partie flexible (PF) comprenant au moins une couche, dite couche de transport (CT) comprenant au moins une piste de cuivre de transmission de signal (P1, P2, P3, PdG, PdD), et au moins une couche de support (CS), ladite au moins une couche de support (CS) étant **caractérisée en ce qu'**elle comprend au moins une piste faisant office de plan de masse (PM) et au moins une piste de protection (TS) contre l'intrusion d'au moins une desdites pistes de transmission de signal, ladite couche de transport comprend au moins une piste de transmission d'un signal à protéger (P1, P2, P3) et une piste de masse (PPdM) reliée audit plan de masse de ladite couche de support par l'intermédiaire d'au moins une via.

2. Circuit imprimé selon la revendication 1, **caractérisé en ce que** ladite couche de transport comprend au moins une piste de transmission d'un signal à protéger (P1, P2, P3) et **en ce que** ladite au moins une piste de protection de ladite au moins une couche de support (CS) est conformée pour recouvrir au moins partiellement ladite au moins une piste de transmission d'un signal à protéger (P1, P2, P3).

3. Circuit imprimé selon la revendication 1, **caractérisé en ce que** ladite au moins une piste faisant office de plan de masse (PM) de ladite couche de support est conformée pour recouvrir au moins partiellement au moins une piste de transmission de signal (P1, P2, P3, PdG, PdD).

4. Circuit imprimé selon la revendication 1, **caractérisé en ce que** ladite couche de transport comprend au moins une piste de transmission d'un signal à protéger (P1, P2, P3) et **en ce que** ladite au moins une piste d'un signal à protéger (P1, P2, P3) de ladite couche de transport (CT) est disposée à proximité et de manière sensiblement parallèle à une droite de symétrie axiale de la dite couche de transport.

5. Circuit imprimé selon la revendication 4, **caractérisé en ce que** ladite au moins une piste de protection (TS) de ladite au moins une couche de support (CS) est conformée pour recouvrir au moins partiellement ladite au moins une piste de transmission d'un signal à protéger (P1, P2, P3), en dessinant une pluralité de circonvolutions sur une surface sensiblement équivalente à la surface occupée par ladite au moins une piste de transmission d'un signal à protéger (P1, P2, P3) sur ladite couche de transport (CT).

6. Circuit imprimé selon la revendication 5, **caractérisé en ce que** ladite au moins une piste faisant office de plan de masse (PM) occupe une surface sensiblement équivalente à la surface occupée par ladite au moins une piste de transmission d'un signal standard (PdG, PdD) sur ladite couche de transport (CT).

## Patentansprüche

1. Leiterplatte (CI), die mindestens einen biegsamen Teil umfasst, wobei der biegsame Teil (PF) mindestens eine Schicht, Transportschicht (CT) genannt, umfasst, die mindestens eine Kupfersignalübertragungsleiterbahn (P1, P2, P3, PdG, PdD) umfasst, und mindestens eine Trägerschicht (CS), wobei die mindestens eine Trägerschicht (CS) **dadurch gekennzeichnet ist, dass** sie mindestens eine Leiterbahn umfasst, die als Erdungsebene (PM) dient, und mindestens eine Leiterbahn (TS) zum Schutz vor Eindringen mindestens einer der Signalübertragungsleiterbahnen, wobei die Transportschicht mindestens eine Leiterbahn eines zu schützenden Signals (P1, P2, P3) und eine Masseleiterbahn (PPdM), die mit der Erdungsebene der Tragschicht über mindestens eine Durchkontaktierung verbunden ist, umfasst.

2. Leiterplatte nach Anspruch 1, **dadurch gekennzeichnet, dass** die Transportschicht mindestens eine Übertragungsleiterbahn eines zu schützenden Signals (P1, P2, P3) umfasst, und dass die mindestens eine Schutzleiterbahn der mindestens einen Tragschicht (CS) gestaltet ist, um mindestens teilweise die mindestens eine Übertragungsleiterbahn eines zu schützenden Signals (P1, P2, P3) abzudecken.

3. Leiterplatte nach Anspruch 1, **dadurch gekennzeichnet, dass** die mindestens eine Leiterbahn, die als Erdungsebene (PM) der Tragschicht dient, gestaltet ist, um mindestens teilweise mindestens eine Signalübertragungsleiterbahn (P1, P2, P3, PdG, PdD) abzudecken.

4. Leiterplatte nach Anspruch 1, **dadurch gekennzeichnet, dass** die Transportschicht mindestens eine Übertragungsleiterbahn eines zu schützenden Signals (P1, P2, P3) umfasst, und dass die mindestens eine Leiterbahn eines zu schützenden Signals (P1, P2, P3) der Transportschicht (CT) in der Nähe und auf im Wesentlichen parallele Art zu einer axialen Symmetriegeraden der Transportschicht angeordnet ist.

5. Leiterplatte nach Anspruch 4, **dadurch gekennzeichnet, dass** die mindestens eine Schutzleiterbahn (TS) der mindestens einen Tragschicht (CS) gestaltet ist, um mindestens teilweise die mindestens eine Übertragungsleiterbahn eines zu schützenden Signals (P1, P2, P3) abzudecken, indem eine Vielzahl von Faltungen auf einer Oberfläche gezeichnet wird, die im Wesentlichen gleich der Oberfläche ist, die von der mindestens einen Übertragungsleiterbahn eines zu schützenden Signals (P1, P2, P3) auf der Transportschicht (CT) belegt wird.

6. Leiterplatte nach Anspruch 5, **dadurch gekennzeichnet, dass** die mindestens eine Leiterbahn, die als Erdungsebene (PM) dient, eine Oberfläche belegt, die im Wesentlichen gleich der Oberfläche ist, die von der mindestens einen Übertragungsleiterbahn eines Standardsignals (PdG, PdD) auf der Transportschicht (CT) belegt wird.

## Claims

1. Printed circuit board (Cl) comprising at least one flexible part, said flexible part (PF) comprising at least one layer, called transport layer (CT), comprising at least one copper track for transmitting a signal (P1, P2, P3, PdG, PdD), and at least one support layer (CS), said at least one support layer (CS) being **characterised in that** it comprises at least one track serving as a ground plane (PM) and at least one track (TS) for protection against intrusion of at least one of said tracks for transmitting a signal, said transport layer comprising at least one track for transmitting a signal to be protected (P1, P2, P3) and one ground track (PPdM) linked to said ground plane of said support layer by means of at least one via.

2. Printed circuit board according to Claim 1, **characterised in that** said transport layer comprises at least one track for transmitting a signal to be protected (P1, P2, P3) and **in that** said at least one protection track of said at least one support layer (CS) is shaped to cover at least part of said at least one track for transmitting a signal to be protected (P1, P2, P3).

3. Printed circuit board according to Claim 1, **characterised in that** said at least one track serving as a ground plane (PM) of said support layer is shaped to cover at least part of at least one track for transmitting a signal (P1, P2, P3, PdG, PdD).

4. Printed circuit board according to Claim 1, **characterised in that** said transport layer comprises at least one track for transmitting a signal to be protected (P1, P2, P3) and **in that** said at least one track for a signal to be protected (P1, P2, P3) of said transport layer (CT) is arranged near and substantially parallel to a line of axial symmetry of said transport layer.

5. Printed circuit board according to Claim 4, **characterised in that** said at least one protection track (TS) of said at least one support layer (CS) is shaped to cover at least part of said at least one track for transmitting a signal to be protected (P1, P2, P3), by drawing a plurality of convolutions on a surface which is substantially equivalent to the surface occupied by said at least one track for transmitting a signal to be protected (P1, P2, P3) on said transport layer (CT).

6. Printed circuit board according to Claim 5, **characterised in that** said at least one track serving as a ground plane (PM) occupies a surface which is substantially equivalent to the surface occupied by said at least one track for transmitting a standard signal (PdG, PdD) on said transport layer (CT).
